(19) Europäisches Patentamt
European Patent Office
Office européen des brevets

(11) EP 2 741 389 B1

(12) EUROPEAN PATENT SPECIFICATION

(45) Date of publication and mention
of the grant of the patent:
**09.09.2015 Bulletin 2015/37**

(51) Int Cl.:
*H02H 3/16* *(2006.01)*    *H02H 3/38* *(2006.01)*
*G01R 31/02* *(2006.01)*    *G01R 31/08* *(2006.01)*
*H02H 1/00* *(2006.01)*    *H02H 7/26* *(2006.01)*

(21) Application number: **12196303.7**

(22) Date of filing: **10.12.2012**

(54) **Ground fault direction determination for medium or high voltage distribution networks**

Erdfehlerrichtungsbestimmung für Mittel- oder Hochspannungsverteilungsnetze

Détermination de la direction de défaut à la terre à moyenne ou haute tension pour des réseaux de distribution

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.06.2014 Bulletin 2014/24**

(73) Proprietor: **ALSTOM Technology Ltd**
**5400 Baden (CH)**

(72) Inventors:
• **Subramanian, Sankara**
**Stafford, ST170AP (GB)**
• **Ha, Hengxu**
**Zibo (CN)**
• **Cui, Liu**
**Beijing (CN)**

(74) Representative: **Ilgart, Jean-Christophe**
**BREVALEX**
**95, rue d'Amsterdam**
**75378 Paris Cedex 8 (FR)**

(56) References cited:
**US-A1- 2012 123 708**

**Description**

**TECHNICAL DOMAIN AND PRIOR ART**

This invention relates to the domain of power system protection and more particularly to ground fault detection in medium to high voltage electrical power systems that serve as distribution networks.

Three phase electrical power systems can be operated as neutral grounded or ungrounded, depending on the condition of their use.

In an ungrounded electrical system, none of its circuit conductors is intentionally grounded to earth.

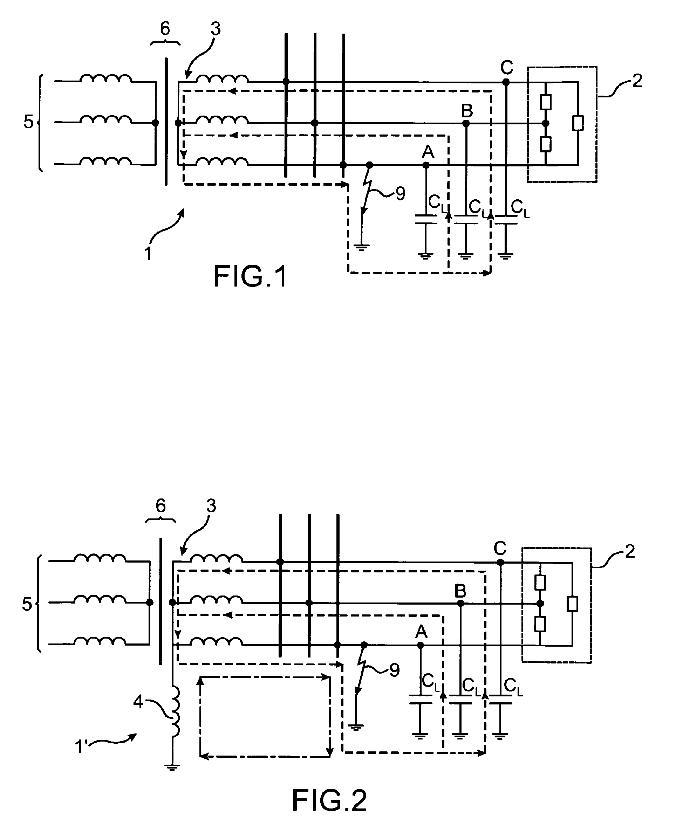

Figure 1 schematically represents a three phase AC ungrounded electrical power system 1, with a source 5, and windings of a source transformer 6, that power supplies a load 2. The path followed by the capacitive current is referenced 7.

In the steady state three-phase symmetrical systems, taking the current in phase line A as reference, the current in the other two phase lines B and C are respectively delayed in time by one-third and two-thirds with respect to the current in phase line A.

In a simplified model, taking into account the imperfections of the lines A,B,C, each phase line has a line capacitance $C_L$ (so-called line-to-ground capacitance, the phase to phase capacitance being neglible here), that is placed in parallel between the phase and the ground.

Each of the three phase lines A,B,C is connected to a pole of either a Y or a delta connected secondary winding 3 coupled to a Y connected primary winding of a power supply (not illustrated). The neutral N of the Y secondary winding 3 is ungrounded.

In case of a single phase-to-ground fault 9 appears on the phase line A, the only path for ground current to flow is through the line-to-ground capacitance $C_L$ of the surrounding system and of the two remaining un-faulted phase lines B and C of the faulted circuit.

In a three phases with neutral ungrounded electrical power system 1 as illustrated in figure 1, once single phase-to-ground fault occurs, there is theoretically no closed circuit, therefore there is no significant short-circuit current and the phase to phase voltages remain symmetrical. Thus, an immediate clearance of the fault is not required and the system is permitted to run for a relatively longer period in the case of a single-phase to ground fault. At most cases, i.e. more than 80 percent, the single-line-to-ground fault is generally a temporary fault, so that the power supply would not be interrupted.

Therefore, many industrial systems like chemical plants or refineries that involve processes that cannot be interrupted without expensive costs or product loss are often operated as neutral ungrounded. This allows the faulted circuit to remain in service while the temporary ground fault is cleared. However, in such systems it is difficult to locate ground faults with current state of the art techniques.

Hence, an ungrounded electrical power system could promote the level of reliability of power supply. However, apart this remarkable advantage, the major issue with ungrounded systems is steady and transient over-voltages.

Indeed, if an accidental ground fault occurs and is allowed to flow for a substantial time, over-voltages can develop in the associated feeder lines.

More specifically, in the event a single phase-to-ground fault occurs in the phase line A of an ungrounded three-phase system, the phase voltage of the faulty phase line A is reduced to the ground potential. This causes the phase voltage in the other phase lines B and C to rise by $\sqrt{3}$ times (This is called steady state over-voltage).

This increase in voltage causes a charging current, $I_c$, between the line-to-ground capacitances. Once the arc is extinguished, the faulty phase voltage will get rise suddenly, which will cause the re-burning of the arc. Once the arc re-burns, it will cause a significant transient over-voltage, as the voltage of healthy phases is superimposed onto the voltage of this charged capacitance.

Such an over-voltage situation can lead to insulation damage and be dangerous for personnel : Indeed, while a ground fault remains on one phase line of an ungrounded three-phase system, personnel contacting one of the other phase lines and ground are subjected to 1.732 times the voltage they would experience on a solidly neutral grounded system.

In neutral ungrounded electrical power systems, in order to limit the over-voltage and eventually avoid the re-burning of an extinguished arc, a resistor (resistance grounding) or an arc suppression coil is connected between the neutral point and ground.

The specifications of the resistor are determined by the user to achieve a desired ground fault current.

When an arc suppression coil is connected between the system's neutral and ground, the system is called a compensated system.

Figure 2 shows a compensated system 1' that power supplies a load 2. The same elements as those illustrated in Figure 1 have the same references and will not be described again.

The neutral point N of the power transformer secondary 3 is grounded through an impedance reactor 4.

The impedance reactor 4, known as a Petersen coil, compensates the capacitive current, decreases the fault arc current as well as limits the voltage of the neutral point, and of course limits the arc recovery voltage, so that it could limit the probability of re-burning of an extinguished arc. The path followed by the inductive current is referenced 8.

The functioning of the Petersen coil connected as illustrated on figure 2 will be now explained in detail for the three phases system 1'.

To obtain an effective cancellation of the capacitive charging currents, current $I_L$ flowing through the Petersen coil has to be equal to current $I_c$.

Therefore, in the event of a single phase-to-ground fault on the phase line A, the capacitive charging current $I_c$ is neutralized by the current $I_L$ across the reactor which is equal in magnitude but 180 degrees out of phase.

Thus, the value of the inductance $Lp$ in the Petersen coil needs to match the value of the phase lines capacitances which may vary as and when modifications in the phase lines are carried out. Hence, the reactance of the Peterson coil is selected in order to achieve ground fault compensation degree $K_c$ given by the following formula.

$$K_c = \frac{1}{\omega_0{}^2 3 L_p C_\Sigma} \qquad\qquad 1)$$

where $L_p$ is the equivalent inductance of the Petersen coil, $\omega_0$ is the fundamental frequency in radian, and $C_\Sigma$ is the total line-to-ground capacitance of all the lines. For resonant compensation, $K_c = 1$; for under-compensation $K_c < 1$; for over compensation, $K_c > 1$.

If the impedance reactor 4 is well tuned, the ground fault current becomes minimal resulting in rush extinction of the fault arc in air.

As mentioned above, it is important to detect and locate faults safely, whether in ungrounded, resistance grounded, or compensated systems so as to be able to plan necessary corrective measures to handle the electrical problem that caused the fault.

As a matter of fact, all grounded and especially ungrounded systems are equipped with a power protection equipment in which electrical variables are monitored to detect the direction of a single-phase-to-ground faults. More precisely, protection equipment includes means that are used to monitor the residual voltage and residual current and means for detecting an electrical fault on a phase line of the system and disconnecting that part of the network in which the fault occurs limiting the size of the disconnected section as far as possible.

The power protection equipment measures via electrical variable measurement means, either the active or the reactive power flowing through specific measurement nodes of the electrical system. The protection equipment operates only if the power is greater than a set threshold and if it is flowing in a given direction determined by a directional relay of the protection equipment. The direction is either a forward direction or a reverse direction, relatively to a measurement node of the system.

In case the protection equipment operates, it is arranged to emit a control signal to handle a fault by controlling one or several of a plurality of circuit breaker units, or to start an external auto-reclose relay.

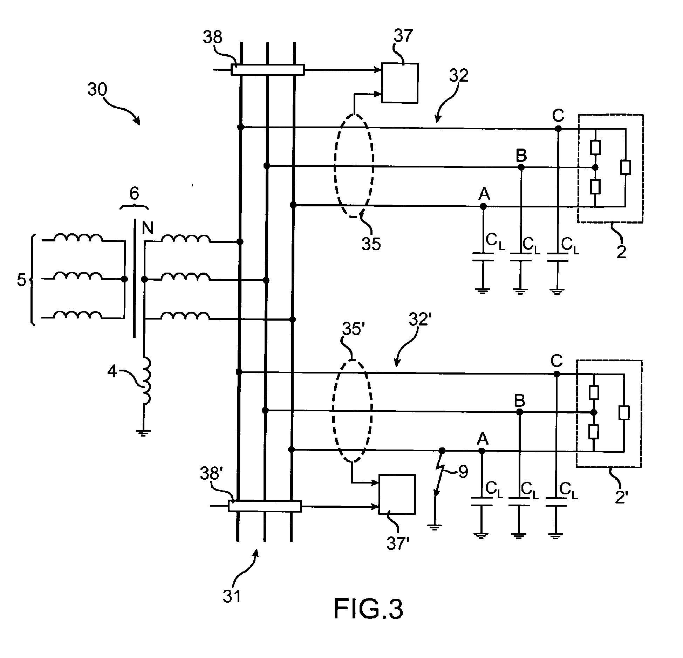

Figure 3 shows schematically an electric power distribution network comprising a basic protection device. The same elements as those illustrated in figures 1 and 2 have the same references and will not be described again.

It is to be noted that the conclusions which will be drawn from the description of figure 3 also applies for ungrounded electrical power systems or resistance grounded electrical power systems.

The protection equipment is shown as applied to an electric power distribution network 30 having a main bus 31 providing power to several feeder lines, where only two feeder lines 32 and 32' are represented. The main bus 31 and the feeder lines 32 and 32' may all be three-phase. On figure 3 they comprise three phase lines A,B,C. Each feeder line power supplies a load 2 (2'). The purpose of the protection equipment is to detect a phase-to-ground fault that can occur on a phase line A,B,C of a feeder line.

The neutral N of the electrical power distribution network 30 is grounded via a Peterson coil 4, which is connected to ground G.

On each feeder lines 32 and 32', there is provided a measurement node, where the residual current $I_r$ of the feeder line is measured.

The measurement of the residual current $I_r$ at the measurement node of a feeder line is made through a coil (ring CT) 35 and 35' around the three phases lines A, B, C of the feeder line.

Besides, the residual voltage $V_r$ of the feeder lines is measured through voltage transformer arrangements 38, 38'.

For each feeder line 32 and 32' is associated a corresponding directional relay 37 and 37', which is connected to the corresponding measurement coil 35,35' of the associated feeder line and to the voltage transformer arrangement 38, 38'.

The directional relay 37, 37' is a microprocessor based relay that includes a voltage detecting unit and a current detecting unit. The voltage detecting unit is arranged to monitor the residual voltage $V_r$ of the set of feeder lines through the voltage transformer arrangement and the current detecting unit is arranged to monitor the residual current $I_r$ in the associated feeder line at the measurement coil of the line.

The current detecting unit and the voltage detecting units are also connected to at least one microcontroller of the relay. The current detecting unit inputs a digital signal indicative of the residual current $I_r$ into the microcontroller. Similarly, the voltage detecting unit inputs a digital signal indicative of the residual voltage $V_r$ into the microcontroller. The microcontroller of the directional relay is arranged to determine the direction of a fault in relation to the corresponding measurement node, by calculating the active or the reactive power flowing through this measurement node.

As shown in the paper entitled "Directional Overcurrent Relaying (67) Concepts", J. Horak, Basler Electr., IEEE, Conference Publications, 2006. 59th Annual Conference for Protective Relay Engineers, 4-6 April 2006, a directional relay senses the direction of power flow at a measurement node by means of phase angle between the residual current $I_r$ and voltage $V_r$. The directional relay creates phasor quantities which are used to calculate torque-like products. The value of the torque product indicates the direction of current flow: for a forward fault, the sign of the torque is negative whereas for a reverse fault, the sign is positive.

A directional relay emits an alarm signal indicative of a phase-to-ground fault occurring on a phase line A,B,C of a feeder line if the active or the reactive power flowing through the measurement node of the feeder line is greater than a set threshold and if the fault is in a given direction in relation to the node where the residual current $I_r$ is measured. The given direction of the fault depends on the programmed settings of the protection equipment.

Indeed, a fault in the forward or a fault in the reverse direction indicates that the fault occurs upstream or downstream respectively of the measurement node at which the residual current is measured.

Directional relays can be implemented in both grounded and ungrounded electrical power systems.

Nowadays there are many techniques to determine the fault direction relatively to a point of a system. However, these techniques use either special hardware with high sampling rates, or special high resolution and accuracy measurements, or using special instruments for special signal injection into the power system.

More specifically, the best existing solutions are based on a zero-sequence network of a single phase-to-ground faulted power system, described for example in the paper entitled "A Review of System Grounding Methods and Zero Sequence Current Sources", Johnson,G. Schroeder, M., Dalke, G., IEEE, , 2008 61st Annual Conference for Protective Relay Engineers, 1-3 April 2008.

A first solution consists in using the instantaneous reactive power to determine the fault direction. This method works properly in the neutral resistance grounded system and in ungrounded systems.

For a compensated electrical power system as illustrated on figure 3, and for a forward directional fault on a feeder line 32, 32', the relationship of residual voltage $V_R$ and residual current $I_R$ of the faulted feeder line 32, 32' at a measurement node of this feeder line is given by the following formula

$$I_R = \left( -\left( \frac{1}{R_\Sigma} + \frac{1}{3R_p} \right) + j.\omega.C_\Sigma \left[ \left( \frac{\omega_0}{\omega} \right)^2 K_c{}^2 - 1 \right] \right) V_R \qquad 2)$$

For a reverse directional fault, the relationship is:

$$I_R = \left( \frac{1}{R_L} + j.\omega.C_L \right) V_R \qquad 3)$$

where $R_L$ is equivalent zero-sequence resistance of the faulted feeder line; $C_L$ is the equivalent capacitance of the faulted feeder line; $R_\Sigma$ and $C_\Sigma$ are respectively the total resistance and capacitance of all the feeder lines; $R_p$ is the equivalent resistance of Petersen coil; $\omega_0$ is the fundamental frequency in radians; $\omega$ is frequency in radians ; $K_c$ is the compensation degree of Petersen coil.

In resonant or over compensated systems, there is no difference in the imaginary part of current between a forward directional fault and a reverse directional fault and therefore, it is impossible to determine the fault direction. Consequently, the first solution does not work correctly for Petersen coil compensated systems.

A second solution, known as the Active power method (or so-called Wattmetric method), employs a Wattmeter to measure the active power. This method is valid for ungrounded electrical power systems, for neutral resistance grounded system as well as Petersen coil compensated systems, however it requires a special current transformer with higher sensitivity, higher accuracy and higher resolution. The Wattmetric method is a common directional technique for compensated systems, but its sensitivity is limited to fault resistances not higher than a few kilo ohms.

The third solution, so called the First half wave method, is employed in a special hardware for ground fault detection for indirectly neutral grounded systems. It is based on the fact that the polarities of residual voltage and current are different for a forward directional fault, and similar for a reverse fault. It is valid for Petersen coil compensated systems, however, it requires special hardware with higher frequency of sampling rates, for example, 3 Khz or even higher (for a fundamental frequency of 50 Hz), due to the fact that it is only valid in short duration not more than 3ms.

US 2012/123708 <u>discloses a method and a system for transient and intermittent earth fault detection and direction determination in a three-phase median voltage electric power distribution system which comprises many lines. The system comprises: sampling means wherein the residual current and residual voltage on said lines are sampled, transient direction detection means based on instantaneous power, random intermittent detection means based on intermittent change of residual current amplitude, means of integrating transient direction and random intermittent detection, and alarm means indicating maintenance personnel to check the status of one line.</u>

So it is clear that each of the following existing solutions is effective, however, none is easily adaptive for all types of the above mentioned electrical power systems.

Therefore, the object of the present invention is to propose a new method for determining the direction of transient ground fault for neutral ungrounded or resistance grounded as well as compensated electrical power system. This method is implemented in a common directional relay with lower sampling rates without any need for special hardwares or costly instruments and measurements.

## PRESENTATION OF THE INVENTION

<u>The invention is more clearly defined in independent claim 1.</u>

This invention is concerned with a method for determining the direction of a ground fault relatively to a measurement node in an three phase electrical power system, comprising the steps of:

a) sampling a residual voltage of said three phase electrical power system and a residual current at said measurement node during a fundamental frequency cycle to obtain respectively a sampled residual voltage signal and a sampled residual current signal;

b) filtering, in a first digital filter, the sampled residual voltage signal and applying a phase shift to the sampled residual voltage signal to extract a phase shifted filtered voltage signal component of the sampled residual voltage signal at a non-integer order of the fundamental frequency and to obtain a phase shifted filtered voltage signal;

c) filtering the sampled residual current signal in a second digital filter to extract a filtered current signal component of the sampled current signal at a non-integer order of the fundamental frequency to obtain a filtered current signal;

d) using the filtered current signal and the phase shifted filtered voltage signal to calculate a transient reactive power flowing through said measurement node;

e) determining the fault direction in function of the sign of the calculated transient reactive power such that if the sign of the calculated transient reactive power is negative, then the fault direction is forward, whereas if the sign of the calculated transient reactive power is positive, then the fault direction is reverse fault.

Advantageously the step e) comprises the steps of:

- e1) comparing the phase shifted filtered voltage signal and the filtered current signal to respective predetermined thresholds;
- e2) limiting the range of the phase shifted filtered voltage signal and the filtered current signal magnitudes into a same interval symmetric around 0 according to the results of the step e1) to obtain a limited phase shifted filtered voltage signal and a limited filtered current signal;
- e3) calculating the transient reactive power using the limited phase shifted filtered voltage signal and the limited filtered current signal;
- e4) comparing the calculated transient reactive power to a negative and positive value of a detection threshold.

Advantageously the method further comprises:

g) calculating the root mean square value of the sampled voltage signal;

h) comparing the calculated root mean square value to a start threshold;

i) comparing the calculated root mean square value with a drawback threshold, said draw back threshold being smaller than the start threshold;

j) extracting oscillations of a signature of the calculated root mean square value;

k) comparing the magnitude of the extracted oscillations with a pulse detection threshold;

l) calculating the number of times the magnitude of the extracted oscillations is larger than the pulse detection threshold during a fundamental frequency cycle;

wherein if the calculated root mean square value is greater than the start threshold and smaller than said draw back threshold and if the number calculated at step 1) is greater than a predetermined number, then said fault is determined as an intermittent fault;

whereas said fault is a permanent fault if the calculated root mean square value is greater than the start threshold and smaller than said drawback threshold during a predetermined interval of time.

The invention is also concerned with a digital band-pass filter for filtering and phase shifting a sampled voltage signal $U_N$ and to extract a phase shifted filtered voltage signal $U_{NH}$ of the sampled voltage signal at an non-integer order of a fundamental frequency to implement the method, wherein said filter comprises calculating means for calculating the following formula:

$$U_{NH} = \left[ a_0 + \sum_{n=1}^{4} a_n.z^{-n} + b_0 + \sum_{n=1}^{2} b_n.z^{-n} \right].U_N$$

where z is a complex variable.

with

$$\begin{cases} a_0 = 1 \\ a_1 = -2.\cos\left(\frac{2.\pi}{N}\right) \\ a_2 = 0 \\ a_3 = 2.\cos\left(\frac{2.\pi}{N}\right) \\ a_4 = -1 \end{cases}$$

and

$$\begin{cases} b_0 = 1 \\ b_1 = 2.\exp\left(-\frac{T_0}{N.T_A}\right).\cos\left(k_F \frac{2.\pi}{N}\right) \\ b_2 = \exp\left(-\frac{T_0}{N.T_A}\right) \end{cases}$$

where: $N$ is the number of samples per fundamental frequency cycle; $T_0$ is a cycle period of fundamental frequency; Ta is the signal sampling time, $T_A$=0.2 s; and $k_F$=4.4 for 220Hz, 6.6 for 330Hz.

The invention is also concerned with a digital band-pass filter for filtering a sampled current signal $I_N$ and to extract a filtered current signal $I_{NH}$ of the sampled current signal at a non-integer order of a fundamental frequency to implement the method, wherein said filter comprises calculating means for calculating the following formula:

$$I_{NH} = \left[ a'_0 + \sum_{n=1}^{4} a'_n.z^{-n} + b'_0 + \sum_{n=1}^{2} b'_n.z^{-n} \right].I_N$$

with

$$\begin{cases} a'_0 = 1 \\ a'_1 = -2.\cos\left(\frac{2.\pi}{N}\right) \\ a'_2 = 2 \\ a'_3 = -2.\cos\left(\frac{2.\pi}{N}\right) \\ a'_4 = 1 \end{cases}$$

and

$$\begin{cases} b'_0 = 1 \\ b'_1 = 2.\exp\left(-\dfrac{T_0}{N.T_A}\right).\cos\left(k_F\dfrac{2.\pi}{N}\right) \\ b'_2 = \exp\left(-\dfrac{T_0}{N.T_A}\right) \end{cases}$$

where: $N$ is the number of samples per fundamental frequency cycle; $T_0$ is a cycle period of fundamental frequency (for $f_0$ = 50Hz, $T_0$ =0. 02 s); Ta is the signal sampling time, $T_A$ = 0.2 s; and $k_F$ = 4.4 for 220Hz, 6.6 for 330Hz.

## BRIEF DESCRIPTION OF THE DRAWINGS

This invention will be better understood after reading the following description of example embodiments given purely for guidance and that are in no way limitative, with reference to the appended figures, wherein :

- Figure 1 schematically represents a three phases AC ungrounded electrical power system that power supplies a load;
- Figure 2 schematically shows a compensated electrical power system that power supplies a load;
- Figure 3 schematically shows an electric power distribution network comprising a basic protection equipment;
- Figure 4 shows a schematic block of the operations performed by the fault direction decision method, according to the present invention;
- Figure 5 shows the structure of direction determination means according to the present invention;
- Figures 6A to 6D show schematic blocks of the operations determining whether the ground fault is a permanent fault, an intermittent fault or a disturbance, according to the present invention, wherein:

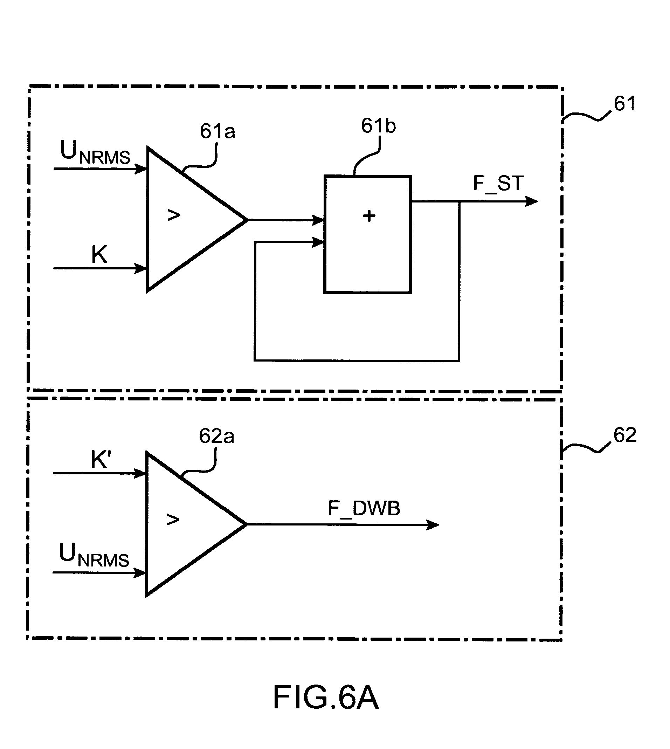

  • Figure 6A shows the structure of a start relay and a drawback relay, according to the present invention;

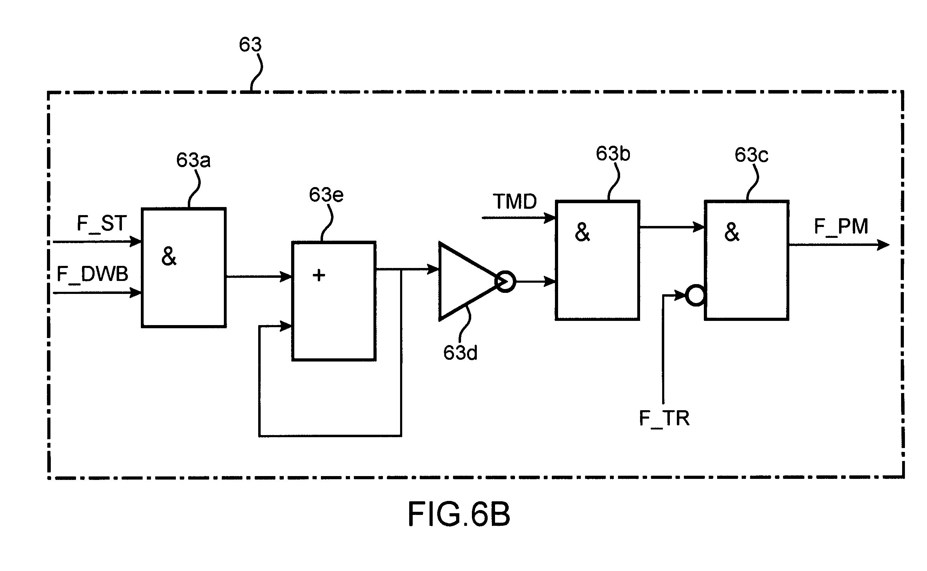

  • Figure 6B shows a permanent fault decision means, according to the present invention;

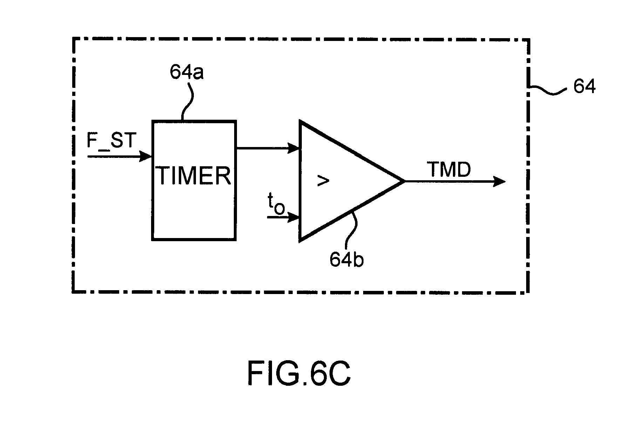

  • Figure 6C shows tunable timer means, according to the present invention;

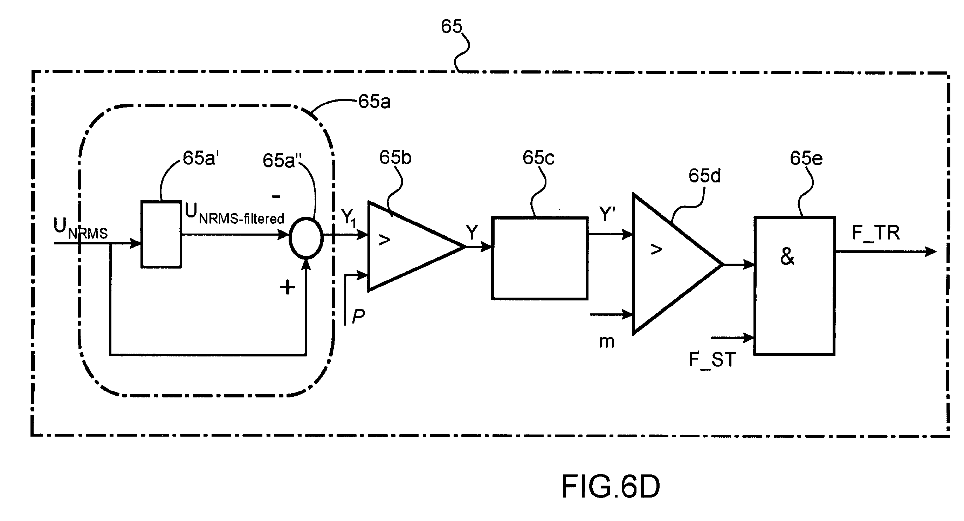

  • Figure 6D shows intermittent fault decision means, according to the present invention;

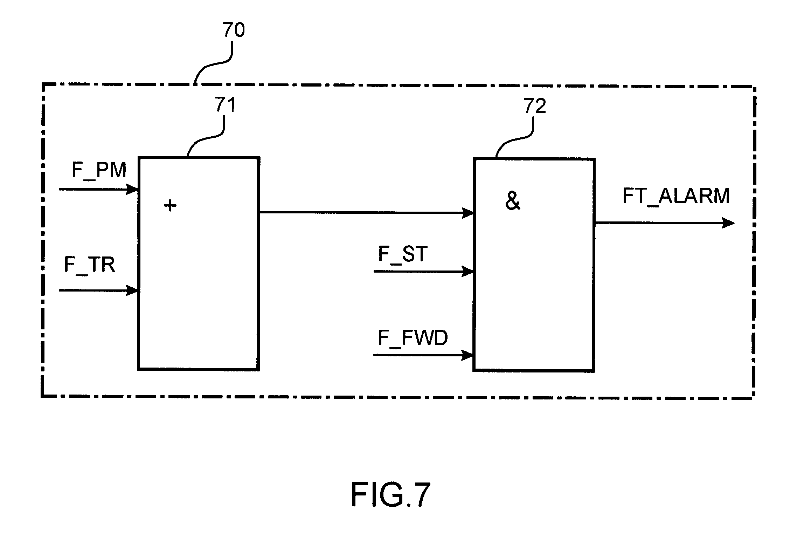

- Figure 7 shows a schematic block of the operations to emit a fault alarm signal, according to the present invention.

Identical, similar or equivalent parts of the different figures have the same references so as to facilitate comparisons between the different figures.
The different parts shown in the figures are not necessarily drawn at the same scale, to make the figures more easily understandable.

## DETAILED PRESENTATION OF PARTICULAR EMBODIMENTS

In the following description, for purposes of explanation and not limitation, specific details are set forth such as particular architectures, interfaces, techniques, etc. in order to provide a thorough understanding of the present invention. However, it will be apparent to those skilled in the art that the present invention may be practiced in other embodiments that depart from these specific details. In other instances, detailed descriptions of well-known devices circuits, and methods are omitted so as not to obscure the description of the present invention with unnecessary details.
All the numerical examples (mainly the thresholds) given throughout the following description are given in a per unit system depending on the electrical power system in which the present invention is applied.
The concept behind the invention is to conceive a high accuracy method for ground fault direction determination by transient reactive power.
To this end, a non-integer order harmonics digital band pass filtering step of the residual current signal and residual voltage signal of a power system is used to extract the information of fault direction.
By eliminating the fundamental frequency $f_0$ (50 Hz) component of these signals, and amplifying non-integer order harmonic components (such as 220Hz or 330Hz for the above fundamental frequency), through a band pass filtering step, a digital high quality band pass filter is easily designed for residual voltage and current. Subsequently, the determination of fault direction can be made by transient reactive power.
The method according to the invention is adaptive for not only neutral Petersen coil grounded systems, but also for ungrounded or resistance grounded systems as it will be described hereafter.

It is to be noted that for a frequency of non-integer order harmonic components (such as 220Hz or 330Hz for a fundamental frequency of 50 Hz) of residual voltage and residual current signals, such as 220Hz or 330Hz, the residual voltage signal leads the residual current signal by nearly 90 degrees for a forward directional fault, however, the residual voltage signal lags the residual current signal by nearly 90 degrees for reverse directional fault, no matter what kind of compensation it is, no matter whether it is ungrounded or Petersen coil grounded or resistance grounded system.

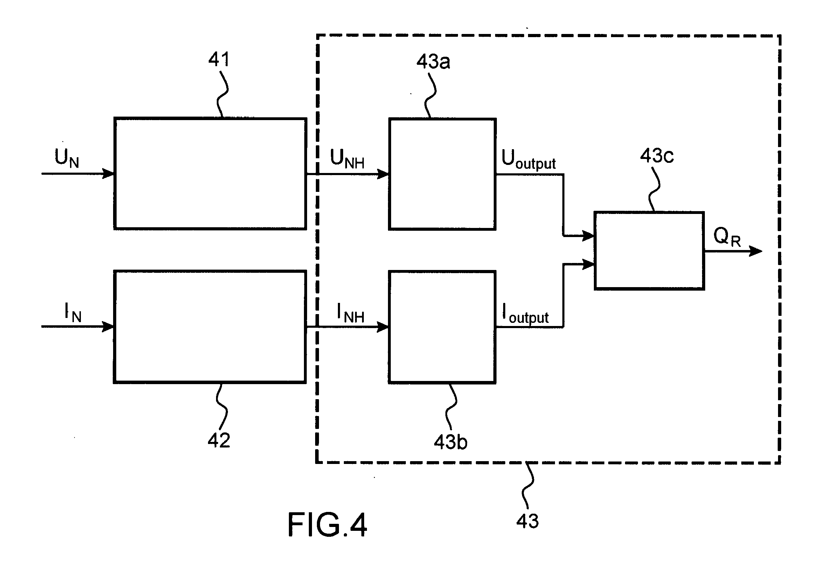

Taking this feature into account, the method according to the invention for determining the direction of a fault will now be explained in detail, in relation to figures 3 and 4.

Referring to figure 3, the invention is shown as applied to the protection equipment of an electric power distribution network 30 having its neutral grounded via a Petersen coil. The following description of the method according to the present invention is however valid for an ungrounded electric power distribution network or a resistance grounded power distribution network.

As already described, figure 3 schematically shows a protection equipment implemented to detect a phase-to-ground fault in a set of three feeders and to perform corrective actions in the event of a fault to handle it. The protection equipment may however be provided for more than three feeders.

It should furthermore be realized that normally there may be several measurement nodes, directional relays or circuit breaker units per feeder in relation to such a network 30.

Each directional relay is a microprocessor based relay that includes a voltage detecting unit and a current detecting unit. The voltage detecting unit is arranged to monitor the residual voltage $V_r$ of a set of three feeder lines through the arrangement of voltage transformers 37. The current detecting unit is arranged to monitor the residual current $I_r$ in the associated feeder line at the measurement node of that line.

The current detecting unit comprises an A/D (analog to digital) converter and inputs a digital signal $I_N$ indicative of the residual current $I_r$ measured at the measurement node into one microcontroller of the directional relay. The voltage detecting unit also comprises an A/D converter and inputs a digital signal $U_N$ indicative of the residual voltage $V_r$ measured by the voltage transformer arrangement into one microcontroller of the directional relay.

The voltage detecting unit as well as the current detecting unit respectively sample the residual voltage $V_r$ and the residual current $I_r$ with low sampling rates, for example 24 samples per fundamental frequency cycle when the latter is equal to 50 Hz. Indeed, no special hardware with higher frequency sampling rates is required to implement the method according to the present invention. Thus, a common directional relay can be used.

Therefore, the microcontroller of common directional relays can be programmed to implement the method according to the present invention.

Figure 4 shows a schematic block of the operation performed by the at least one microcontroller of a common directional relay to according to the method of the present invention.

In this example, the phase-to-ground fault direction is chosen to be the forward direction.

When a fault occurs in the feeder line, the sampled residual voltage $U_N$ signal and the residual current $I_N$ signal pass through digital band pass filters 41 and 42 respectively, whose central frequencies $f_{band}$ are non-integer orders of fundamental frequency $f_0$. The central frequency of the digital band pass filter 41 is the same as that of the digital band pass filter 42.

For a 50 Hz fundamental frequency, the central frequency $f_{band}$ of the filters is set to be preferably 220 Hz, 330 Hz but can also be 440 Hz or 660 Hz.

In a digital band-pass filter 41 and 42, not only the signal component at the central frequency $f_{band}$ set for the filter is amplified, but also the signal component at the fundamental frequency $f_0$ is eliminated.

Eliminating the fundamental frequency $f_0$ component, and thereby using transient reactive power allow the method according to the invention to be adaptive for not only neutral Petersen coil grounded system, but also for ungrounded or resistance grounded system.

Indeed, for a neutral Petersen coil grounded system, it is to be noted that for a fundamental frequency component of residual voltage and current, i.e. $\omega_0 = \omega$, equation 1 implies the following:

A. if it is an under compensated system, residual voltage $V_r$ leads residual current $I_r$ by 90 degrees as forward directional fault, however lags to current by 90 degrees as reverse directional fault;

B. if it is a resonant compensated system, the imaginary part of current is zero as forward fault occurs;

C. if it is an over compensated system, residual voltage lags residual current by 90 degrees for both forward and reverse directional faults.

Therefore, if it is a resonant or an over compensated system, there is no difference in the imaginary part of the residual current between the forward directional fault and reverse directional fault. Thus, the elimination of the fundamental frequency component of $U_N$ and $I_N$ allows for a better determination of the fault direction for all types of electrical power systems.

The digital band-pass filters 41 and 42 have the same structure; however the filters' parameters are different so that a phase shift of +90 degrees is performed on the residual voltage signal $\mathbf{U_N}$. This phase shift allows implementing a determination of the direction of the fault by using the sign of the reactive power as it will be shortly described.

Alternatively, a -90 degree phase shift could be done on the residual current signal.

The digital band-pass filter 41 comprises calculating means for obtaining a filtered and phase shifted voltage output signal $\mathbf{U_{NH}}$ from the digital voltage signal $\mathbf{U_N}$. The calculating means performs the following equation, given in z-transform:

$$\mathrm{U}_{NH}(z) = \left[ a_0 + \sum_{n=1}^{4} a_n . z^{-n} + b_0 + \sum_{n=1}^{2} b_n . z^{-n} \right] . \mathrm{U}_N(z) \qquad 4)$$

where z is a complex variable, $\mathbf{U_{NH}(z)}$ is a complex plane representation, $\mathbf{U_N(z)}$ is a complex plane representation with

$$\begin{cases} a_0 = 1 \\ a_1 = -2.\cos\left(\frac{2.\pi}{N}\right) \\ a_2 = 0 \\ a_3 = 2.\cos\left(\frac{2.\pi}{N}\right) \\ a_4 = -1 \end{cases} \qquad 5)$$

and

$$\begin{cases} b_0 = 1 \\ b_1 = 2.\exp\left(-\frac{T_0}{N.T_A}\right).\cos\left(k_F \frac{2.\pi}{N}\right) \\ b_2 = \exp\left(-\frac{T_0}{N.T_A}\right) \end{cases} \qquad 6)$$

where: $\boldsymbol{N}$ is the number samples per fundamental frequency cycle; $\boldsymbol{T_0}$ is a cycle period of fundamental frequency (for 50Hz, To =0.02 s); $\boldsymbol{T_A}$ is the signal sampling time, $\boldsymbol{T_A}$=0.2 s; and $\mathbf{k_F}$=4.4 for 220Hz, 6.6 for 330Hz.

The digital band-pass filter 42 comprises calculating means for obtaining a filtered current output signal $\mathbf{I_{NH}}$ from the digital current signal $\mathbf{I_N}$. The calculating means performs the following equation, given in z-transform:

$$\mathrm{I}_{NH}(z) = \left[ a'_0 + \sum_{n=1}^{4} a'_n . z^{-n} + b'_0 + \sum_{n=1}^{2} b'_n . z^{-n} \right] . \mathrm{I}_N(z) \qquad 7)$$

Where z is a complex variable, $\mathbf{I_{NH}(z)}$ is a complex plane representation, $\mathbf{I_N(z)}$ is a complex plane representation with

$$\begin{cases} a'_0 = 1 \\ a'_1 = -2.\cos\left(\frac{2.\pi}{N}\right) \\ a'_2 = 2 \\ a'_3 = -2.\cos\left(\frac{2.\pi}{N}\right) \\ a'_4 = 1 \end{cases} \qquad 8)$$

and

$$\begin{cases} b'_0 = 1 \\ b'_1 = 2.\exp\left(-\frac{T_0}{N.T_A}\right).\cos\left(k_F\frac{2.\pi}{N}\right) \\ b'_2 = \exp\left(-\frac{T_0}{N.T_A}\right) \end{cases} \qquad 9)$$

Returning to figure 4 subsequently, after the sampled signals of residual voltage $U_N$ and current $I_N$ have passed through the digital band pass filtering means 41 and 42 respectively, the transient reactive power $Q_R$ is calculated by a calculating means 43 to determine the direction of the power flowing through the measurement node where the residual current $I_r$ is measured.

More specifically, the calculating means compares, in a digital sign filter 43a, the voltage $U_{NH}$ output from the band pass filtering means 41 to a reference voltage $U_{set}$.

Similarly, the calculating means compares, in digital sign filter 43b, the current $I_{NH}$ output from the band pass filtering means 42 to a reference current $I_{set}$.

The references $U_{set}$ and $I_{set}$ are respectively set as a pre-fault Root Mean Square (RMS) value of $U_N$ and $I_N$ that are multiplied by a predetermined factor and added with a constant 0,05. In the described embodiment, the predetermined factor is chosen equal to 1.5.

```
Uset = 0,05 + 1,5 * UNRMS_Prefault
```

```
Iset = 0,05 + 1,5 * INRMS_Prefault
```

The above settings are all in per-unit.

The RMS value of $U_N$, so-called $U_{NRMS}$ is given by the following equation:

$$U_{NRMS} = \sqrt{\frac{1}{N}\sum_{k=1}^{N} U_N^2(k)} \qquad 10)$$

The RMS value of $IN$, so-called $I_{NRMS}$ is given by the following equation:

$$I_{NRMS} = \sqrt{\frac{1}{N}\sum_{k=1}^{N} I_N^2(k)} \qquad 11)$$

The pre-fault RMS values $U_{set}$ and $I_{set}$ are stored in the memory of the common directional relay.

The signal $U_{output}$ output from the digital sign filter 43a, that compares $U_N$ with $U_{set}$ is given by the following equation:

$$U_{output} = \begin{cases} 1 \text{ if } U_N > U_{set} \\ 0 \text{ if } -U_{set} \leq U_N \leq U_{set} \\ -1 \text{ if } U_N < -U_{set} \end{cases} \qquad 12)$$

Therefore, thanks to the digital sign filter 43a, the range of $U_{output}$ is limited into [-1,1]. A different interval may obviously be selected.

The signal $I_{output}$ output from the digital sign filter, that compares $I_N$ with $I_{set}$ is given by the following equation:

$$I_{output} = \begin{cases} 1 \text{ if } I_N > I_{set} \\ 0 \text{ if } -I_{set} \leq I_N \leq I_{set} \\ -1 \text{ if } I_N < -I_{set} \end{cases} \qquad 13)$$

Therefore, thanks to the digital sign filter 43b, the range of $I_{output}$ is limited into [-1,1]. A different interval may obviously be selected.

Subsequently, the reactive power $Q_R$ is calculated by a reactive power calculation means 43c, that calculate the following summation formula:

$$Q_R = \sum_{k=1}^{N} U_{output}(k) . I_{output}(k) \qquad\qquad 14)$$

Thanks to the digital sign filters 43a and 43b, the range of reactive power $Q_R$ is limited thereby enabling to easily set a detection threshold $|S| > 0$, that allows to determine the sign of $Q_R$. In the described embodiment of the invention, as the range of $Q_R$ is limited into [-1, 1], the detection threshold $|S|$ is selected equal to 0.1.

Then, the fault direction is determined in a forward direction determination means 44 and a reverse direction determination means 45.

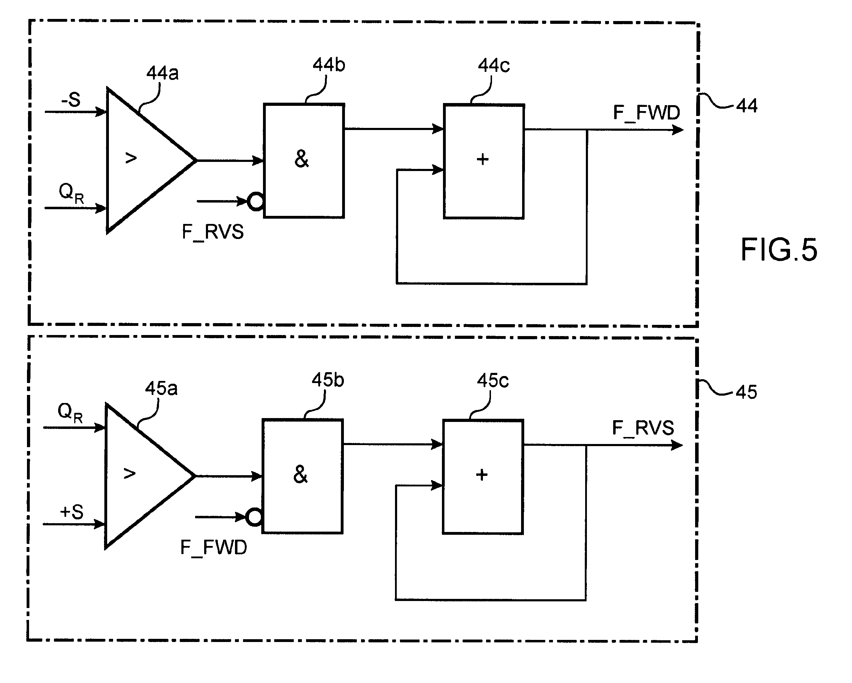

Figure 5 shows the structure of direction determination means 44 and 45.

The forward direction determination means 44 outputs a Boolean flag signal F_FWD indicative of a forward direction decision whereas the reverse direction determination means 45 output a Boolean flag signal F_RVS indicative of a of reverse direction decision.

In principle, if the value of $Q_R$ is less than the negative value of the detection threshold -S (i.e - 0.1 in the described embodiment), then a forward direction decision is made, and the direction determination means 44 and 45 respectively output Boolean signals F_FWD=1 and F_RVS=0.

Otherwise, if the value of the reactive power $Q_R$ is more than the positive value of the detection threshold S (i.e. 0.1 in the described embodiment), then a reverse direction decision is made, and the direction determination means 44 and 45 respectively output Boolean signals F_FWD=0, and F_RVS=1.

The forward direction determination means 44 like the reverse direction determination means 45 comprises a comparator, a logic gate "AND" and a logic gate "OR".

As to the forward direction determination means 44, the reactive power $Q_R$ is compared to the negative value, i.e. -S, of the detection threshold S in the comparator 44a. If the value of $Q_R$ is less than -S, then the result of the comparison is 1, otherwise the result is 0. Further, the logic gate 'AND" 44b receives as inputs, the output of the comparator 44a and the inverse of the Boolean flag signal F_RVS output from the reverse direction determination means 45. The logic output of the logic gate "AND" 44b is introduced as an input to the logic gate "OR" 44c that output the Boolean flag signal F_FWD. The signal F_FWD is also used as a feedback input into the logic gate "OR" 44c.

As to the reverse direction determination means 45, reactive power $Q_R$ is compared to the positive value, i.e. S, of the detection threshold S in the comparator 45a. If the value of $Q_R$ is greater than S, then the result of the comparison is 1, otherwise the results is 0. The logic gate "AND" 45b receives as inputs, the output of the comparator 45a and the inverse of the Boolean flag signal F_FWD output from the forward direction determination means 44. The output of the logic gate "AND" 45b is introduced as an input to the logic gate "OR" 45c that outputs the Boolean flag signal F_RVS. The logic signal F_RVS is reintroduced as a feedback input into the logic gate "OR" 45c.

The fault direction determination method according to the present invention offers a great accuracy and allows detecting the direction of the fault without suffering from the non-linearity of a load connected to a feeder. As a matter of fact, the harmonics generated by the loads are mainly 3rd, 5th, 7th, 11th order of the fundamental frequency $f_0$ of the power distribution network 30, so that, the non-integer order harmonic components are not significantly influenced by the non-linear loads. Hence, the method according to the invention gives a high rate of decision concerning the direction of a fault.

Once a decision has been made concerning the fault direction, the method according to the invention may be further completed by the characterization of the fault so as to determine whether it is a permanent fault, intermittent fault or a disturbance.

Indeed, the corrective actions performed by a directional relay in which the method according to the invention is implemented will be different whether is a permanent fault, intermittent fault or a disturbance.

Figures 6A to 6D show schematic blocks of the operations determining whether the ground fault is a permanent fault, an intermittent fault or a disturbance.

Disturbances are generated by non-synchronized actions of circuit breaker units controlled by the directional relays respectively. It is to be noted that the signature of a residual voltage $V_r$, i.e. the root mean square value of $U_N$, in case of a subsequent opening, closing and reopening of a circuit breaker will lead to at most 4 pulses during a fundamental frequency cycle. Then, it is understood that the signature of a residual voltage that leads to more than 4 pulses is indicative of an intermittent or permanent fault.

Therefore, according to the present invention, the characterization of the fault is only made on the basis of the sampled residual voltage signal $U_N$.

The characterization of the fault according to the invention comprises four steps, that are performed by at least one microcontroller of a directional relay. The first and the second steps are performed at the same time. Similarly, the third and the fourth steps are performed at the same time;

The first and the second steps consists in determining whether the fault is a disturbance or not, whereas the third and the fourth steps respectively consist in determining whether the fault is a permanent or an intermittent fault.

The operations performed in the first and second steps are shown on figure 6A.

The operations performed in the third step are shown on figures 6B and 6C and the operations performed in the fourth step are shown on figure 6D.

Referring to figure 6A, the first step is performed in a start relay 61 that comprises a comparator 61a and a logic gate "OR" 61b. The start relay 61 is provided to detect an abnormal event that can be indicative of a fault.

The first step consists in comparing the RMS value $U_{NRMS}$ of the residual voltage calculated by the calculation means with a start threshold $K$ in the described embodiment; the start threshold $K$ is equal to 0.1. The comparison is performed in the comparator 61a that outputs a Boolean signal equals to 1 if $U_{NRMS}$ is larger than $K$, and equates to 0 otherwise.

The signal output from the comparator 61a is input into the logic gate "OR" 61b. The logic gate "OR" 61b outputs a Boolean start flag signal F_ST which is also feed back into the logic gate "OR" 61b.

Therefore, in output of the start relay 61, the Boolean start flag signal F_ST is equal to 1 if during a sample, $U_{NRMS}$ is larger than $K$, and is equal to 0 otherwise. When F_ST=1, then the start relay 61 picks up.

The second step is performed in a drawback relay 62 that comprises a comparator 62a.

The second step consists in comparing the RMS value $U_{NRMS}$ of the residual voltage calculated by the calculation means with a drawback threshold $K'$, with $|K'| < |K|$ so as to determine if the RMS value $U_{NRMS}$ of the residual voltage draws back. In the described embodiment, the drawback threshold $K'$ is chosen equal to 0.09. The comparison is performed in a comparator 62a that outputs a Boolean draw back flag signal F_DWB equals to 1 if $U_{NRMS}$ is smaller than $K$, and equals to 0 otherwise.

Now referring to figure 6B, the third step is subsequent to the first and second steps. The start flag signal F_ST and drawback flag signal F_DWB are input into a permanent fault decision means 63 to determine whether the fault is permanent or not.

In principle, if the start relay 61 picks up, i.e. F_ST=1 and the drawback relay 62 does not draw back, i.e. F_DWB=0 during a predetermined interval of time $t_0$, then the fault is a permanent fault and therefore F_PM=1. Otherwise, the fault cannot be a permanent fault and F_PM=0.

More specifically, the third step is performed in a permanent fault decision means 63 comprising three logic gates "AND" 63a, 63b, 63c, a logic gate "NO" 63d, and a logic gate "OR" 63e.

The first logic gate "AND" 63a receives the signals F_ST and F_DWB as inputs. The output of the first logic "AND" 63a is sent to a logic gate "OR" 63e which has a feedback input to hold on its output signal. The output of the logic gate "OR" 63e is input into the logic gate "NO" 63d. The output of the logic gate "NO" 63d is then input into the second logic gate "AND" 63b. The second logic gate "AND" 63b also receives as input a signal TMD which is given by a tunable timer means 64.

The tunable timer means 64, illustrated in figure 6C, comprises a timer 64a and a comparator 64b. The timer means 64 is activated as soon as the start relay 61 picks up, i.e. F_ST=1.

The timer 64 counts the duration of the signal F_ST during which the start relay 61 picks up. The duration value is compared, in the comparator, to a predetermined interval of time $t_0$. The Boolean signal TMD output from the comparator 64b is equal to 1 if the period during which the start relay picks up is greater than the predetermined interval of time $t_0$, and is equal to 0 otherwise.

In the described embodiment of the invention, the predetermined interval of time $t_0$ is chosen to be equal to 1.5 s.

The predetermined interval of time **to** must be set according to the chosen sampling period in order to define a delay necessary for permanent or intermittent fault decision making.

Returning to the permanent fault decision means 63, the output of the second logic gate "AND" 63b is input into the third logic gate "AND" 63c.This gate also receives as input the inverse of a flag signal F_TR, indicative of an intermittent fault, so as to check whether the fault is not an intermittent fault.

The third logic gate "AND" 63c outputs the Boolean flag signal F_PM indicative of permanent fault decision.

The flag signal F_TR is output from an intermittent fault decision means 65, described later in relation with the fourth step as in FIG 6D.

The functioning of the permanent fault decision means 63 will now be explained in detail:

In the case of a permanent fault, and during the predetermined interval of time $t_0$, the start relay 61 picks up, i.e. F_ST=1, and the drawback relay 62 does not pick up, i.e. F_DWB=0. In the first logic gate "AND" 63a, the result of the logic "AND" of F_ST and F_DWB is zero. After passing through the logic gate "NO" 63d, the result is changed into 1. After 1.5s time delay, the permanent fault decision relay 63 picks up, i.e. F_PM=1. The fault is determined to be a permanent fault.

If it is not a permanent fault, and during the predetermined interval of time $t_0$, even if the start relay 61 trips, F_ST=1, the drawback relay 62 will pick up during the predetermined interval of time to , therefore the signal F_DWB=1, so that the result of the first logic gate "AND" 63a is 1. Then the result is held on using the logic gate "OR" 63e by an output feedback. After passing through the logic gate "NO" 63d, the output of permanent fault decision means 63 is zero, i.e. F_PM=0. The fault is determined to be a non permanent fault.

During the fourth step, the RMS value $U_{NRMS}$ of the residual voltage is input into intermittent fault decision means 65, which mainly consists of an average high pass filter and a Pulse counter to determine whether it is an intermittent fault or not, through an indicative Boolean flag signal F_TR.

The structure of an intermittent fault decision means 65 is shown on figure 6D.

In principle, the oscillations of the signature of the RMS value $U_{NRMS}$ are extracted thanks to the average high pass filter 65a and are further processed, in a comparator 65b, to become pulses. After that, the pulses are input into a pulse counter 65b. If the number of pulses are more than a predetermined number m, then the fault is determined as an intermittent arc fault and the intermittent fault decision relay 65 picks up, i.e. its output is the Boolean flag signal F_TR=1. Otherwise, the fault is not determined as intermittent fault, F_TR=0.

The predetermined number m is selected to be 6 in the described embodiment. As seen above, the predetermined number must be set greater than 4 so as to eliminate disturbances.

The purpose of the high pass filter 65a is to extract the oscillations super-positioned on the signature of RMS value $U_{NRMS}$ of the residual voltage $V_r$.

More precisely, the average high pass filter 65a is constituted by a digital average filter 65a' and a subtracting means 65a". As a matter of fact, the high pass filtering is made by subtracting through the subtracting means 65a", an average filtered signal $U_{NRMS\text{-}filtered}$ of the signal $U_{NRMS}$ from the input signal $U_{NRMS}$ so as to obtain an average high pass filtered signal $y_1$.

The average filtered signal $U_{NRMS\text{-}filtered}$ is obtained in output of the average filterer 65a' in which the following algorithm is implemented:

$$U_{NRMS-filtered}(n) = \frac{U_{NRMS}(n)+(N-1).U_{NRMS-filtered}(n-1)}{N} \qquad 15)$$

for $n$ = 0, 1, ... , $N$ - 1; $U_{NRMS\text{-}filtered}(n)$ = summation/n (that is the average of these values) and $U_{NRMS}(n)$ = 0 otherwise; where $N$ is the number of samples per fundamental frequency cycle.

Therefore, the average high pass filter 65a is implemented as:

$$y_1(n) = U_{NRMS}(n) - U_{NRMS-filtered}(n) \qquad 16)$$

for $n$ = 0, 1, ..., $N$ - 1; $y(n)$ - 0 and $U_{NRMS}(n)$ = 0 and $y_1(n)$ =0 , otherwise.

where $y_1$ is the output signal of the average high pass filter 65a.

The filtered signal $y_1$ output from the average high pass filter 65a is processed into pulses by comparing its value with a pulse detection threshold $P$, which is selected to be 0.08 in the described embodiment. The comparison is performed by a comparator 65b that receives as inputs the output of the average high pass filter 65a as well as the predetermined number $n$.

At each sample, the Boolean signal Y output from the comparator is equal to 1 if the filtered signal $y_1$ is superior to the pulse detection threshold and 0 otherwise.

The Boolean signal Y is introduced as input of the pulse counter 65c. During a fundamental frequency cycle, the pulse counter outputs an integer Y' that is incremented at each sample if the Boolean signal Y=1 during the sample.

The signal Y' is introduced as input of a comparator 65d that compares the value of Y' with the predetermined number m. Once the value of Y' is greater than m, the Boolean signal in output of the comparator 65d is switched into 1.

The output of the comparator is introduced into a logic gate "AND" 65e that also receives as input the flag signal F_ST.

Therefore, in case the fault is an intermitted fault, and if the start relay 61 picks up, i.e. F_ST=1, then the intermittent fault decision relay 65 picks up, i.e. F_TR=1. Otherwise the fault is not an intermitted fault and F_TR=0.

Once a decision has been made concerning the characterization of the fault and if the latter is determined as a permanent fault or intermittent arc fault, a fault alarm can further be generated. Indeed, according to the above described method, disturbances are eliminated and thus, there are no risks that a disturbance can be considered as a fault.

Figure 7 shows a schematic block of the operations to emit a fault alarm signal.

The fault alarm signal FT_ALARM is provided by an alarm means 70. The alarm means 70 comprises a logic gate "OR" 71 and a logic gate "AND" 72.

The logic gate "OR" 71 receives as input the Boolean flag signal F_PM provided by the permanent fault decision means 64 and the Boolean flag signal F_TR provided by the intermittent fault decision means 65. The result of the logic gate "OR" 71 is input into the logic gate "AND" 72 that also receives as input the Boolean flag signal F_ST provided by the start relay 61 and the Boolean flag signal F_FWD provided by the forward direction determination means 44. The logic gate "AND" 72 output a Boolean flag signal FT_ALARM.

If the fault is determined as a permanent fault or intermittent arc fault, and if F_ST=1 as well as F_FWD=1, then a fault alarm is emitted, and the Boolean flag signal FT_ALARM switch to 1. That is, a forward directional ground fault is detected.

Once a forward directional ground fault is detected, corrective measures can be performed by the protection equipment of the electrical power system 30.

**Claims**

1. A method for determining the direction of a ground fault relatively to a measurement node in an three phase electrical power system, comprising the following step of:

   a) sampling a residual voltage ($V_r$) of said three phase electrical power system (30) and a residual current ($I_r$) at said measurement node during a fundamental frequency cycle to obtain respectively a sampled residual voltage signal ($U_N$) and a sampled residual current signal ($I_N$);
   **characterized in that** it further comprises the following steps:
   b) filtering, in a first digital filter (41), the sampled residual voltage signal ($U_N$) and applying a 90 degrees phase shift to the sampled residual voltage signal to extract a phase shifted filtered voltage signal component of the sampled residual voltage signal at a non-integer order of the fundamental frequency to obtain a phase shifted filtered voltage signal ($U_{NH}$) ;
   c) filtering, in a second digital filter, the sampled residual current signal ($I_N$) to extract a filtered current signal component of the sampled residual current signal at a non-integer order of the fundamental frequency to obtain a filtered current signal ($I_{NH}$) ;
   d) using the filtered current signal ($I_{NH}$) and the phase shifted filtered voltage signal ($U_{NH}$) to calculate a transient reactive power ($Q_R$) flowing through said measurement node;
   e) determining the fault direction in function of the sign of the calculated transient reactive power ($Q_R$) such that if the sign of the calculated transient reactive power is negative, then the fault direction is forward, whereas if the sign of the calculated transient reactive power is positive, then the fault direction is reverse.

2. A method for determining the direction of fault in an electrical power system according to claim 1, wherein the step e) comprises the steps of:

   - e1) comparing the phase shifted filtered voltage signal ($U_{NH}$) and the filtered current signal ($I_{NH}$) to respective predetermined thresholds (($V_{set}$; $I_{set}$);
   - e2) limiting the range of the phase shifted filtered voltage signal and the filtered current signal magnitudes into a same interval symmetric around 0 according to the results of the step e1) to obtain a limited phase shifted filtered voltage signal ($U_{output}$) and a limited filtered current signal ($I_{output}$);
   - e3) calculating the transient reactive power ($Q_R$) using the limited phase shifted filtered voltage signal and the limited filtered current signal;
   - e4) comparing the calculated transient reactive power to a negative and positive value of a detection threshold (S).

3. A method for determining the direction of fault in an electrical power system according to claim 1 or 2, further comprising:

   g) calculating the root mean square value ($U_{NRMS}$) of the sampled voltage signal;
   h) comparing the calculated root mean square value to a start threshold ($K$);
   i) comparing the calculated root mean square value with a drawback threshold ($K'$), said drawback threshold being smaller than the start threshold;
   j) extracting oscillations of a signature of the calculated root mean square value ;
   k) comparing the magnitude of the extracted oscillations with a pulse detection threshold ($P$);
   l) calculating the number of times the magnitude of the extracted oscillations is larger than the pulse detection threshold (**P**) during a fundamental frequency cycle;

wherein if the calculated root mean square value is greater than the start threshold (**K**) and smaller than said drawback threshold (**K'**) and if the number calculated at step 1) is greater than a predetermined number (m), then said fault is determined as an intermittent fault;
whereas said fault is a permanent fault if the calculated root mean square value is greater than the start threshold (**K**) and smaller than said drawback threshold (**K'**) during a predetermined interval of time (**$t_o$**).

4. A digital band-pass filter (41) for filtering and phase shifting a sampled voltage signal $U_N$ and to extract a phase shifted filtered voltage signal $U_{NH}$ of the sampled voltage signal at an non-integer order of a fundamental frequency $f_0$ to implement the method according to claim 1, wherein said filter comprises calculating means for calculating the following formula:

$$\mathbf{U}_{NH} = [a_0 + \sum_{n=1}^{4} a_n \cdot z^{-n} + b_0 + \sum_{n=1}^{2} b_n \cdot z^{-n}] \cdot \mathbf{U}_N$$

where z is a complex variable.
with

$$\begin{cases} a_0 = 1 \\ a_1 = -2 \cdot \cos\left(\frac{2 \cdot \pi}{N}\right) \\ a_2 = 0 \\ a_3 = 2 \cdot \cos\left(\frac{2 \cdot \pi}{N}\right) \\ a_4 = -1 \end{cases}$$

and

$$\begin{cases} b_0 = 1 \\ b_1 = 2 \cdot \exp\left(-\frac{T_0}{N \cdot T_A}\right) \cdot \cos\left(k_F \frac{2 \cdot \pi}{N}\right) \\ b_2 = \exp\left(-\frac{T_0}{N \cdot T_A}\right) \end{cases}$$

where: **N** is the number of samples per fundamental frequency cycle; **$T_0$** is a cycle period of the fundamental frequency fo; Ta is the signal sampling time, **$T_A$**=0.2 s; and **$k_F$**=4.4 for fo= 220Hz, 6.6 for $f_0$= 330Hz.

5. A digital band-pass filter (41) for filtering a sampled current signal $I_N$ and to extract a filtered current signal $I_{NH}$ of the sampled current signal at a non-integer order of a fundamental frequency **$f_0$** to implement the method according to claim 1, wherein said filter comprises calculating means for calculating the following formula:

$$\mathbf{I}_{NH} = [a'_0 + \sum_{n=1}^{4} a'_n \cdot z^{-n} + b'_0 + \sum_{n=1}^{2} b'_n \cdot z^{-n}] \cdot \mathbf{I}_N$$

with

$$\begin{cases} a'_0 = 1 \\ a'_1 = -2\cdot\cos\left(\frac{2\cdot\pi}{N}\right) \\ a'_2 = 2 \\ a'_3 = -2\cdot\cos\left(\frac{2\cdot\pi}{N}\right) \\ a'_4 = 1 \end{cases}$$

and

$$\begin{cases} b'_0 = 1 \\ b'_1 = 2\cdot\exp\left(-\frac{T_0}{N\cdot T_A}\right)\cdot\cos\left(k_F\frac{2\cdot\pi}{N}\right) \\ b'_2 = \exp\left(-\frac{T_0}{N\cdot T_A}\right) \end{cases}$$

where: $N$ is the number of samples per fundamental frequency cycle; $T_0$ is a cycle period of the fundamental frequency fo; Ta is the signal sampling time, $T_A$=0.2 s; and $k_F$=4.4 for fo= 220Hz, 6.6 for $f_0$= 330Hz.

**Patentansprüche**

1. Verfahren zur Bestimmung der Richtung eines Erdungsfehlers in Bezug auf einen Meßknoten in einem dreiphasigen elektrischen Stromsystem, umfassend den folgenden Schritt:

a) Abtasten einer Restspannung ($V_r$) des dreiphasigen elektrischen Stromsystems (30) sowie eines Reststroms ($I_r$) an dem besagten Meßknoten während eines Grundfrequenzzyklus, um dadurch entsprechend ein abgetastetes Restspannungssignal ($U_N$) sowie ein abgetastetes Reststromsignal ($I_N$) zu erhalten, **dadurch gekennzeichnet, daß** das Verfahren ferner die folgenden Schritte aufweist:
b) Filtern des abgetasteten Restspannungssignals ($U_N$) in einem ersten digitalen Filter (41) und Aufbringung einer 90 ° -Phasenverschiebung auf das abgetastete Restspannungssignal, um eine phasenverschobene, gefilterte Spannungssignalkomponente des abgetasteten Restspannungssignals zu gewinnen und dadurch ein phasenverschobenes, gefiltertes Spannungssignal ($U_{NH}$) zu erhalten;
c) Filtern des abgetasteten Reststromsignals ($I_N$) in einem zweiten digitalen Filter, um eine gefilterte Stromsignalkomponente des abgetasteten Reststromsignals bei einer nicht ganzzahligen Ordnung der Grundfrequenz zu gewinnen und dadurch ein gefiltertes Stromsignal ($I_{NH}$) zu erhalten;
d) Verwenden des gefilterten Stromsignals ($I_{NH}$) sowie des phasenverschobenen, gefilterten Spannungssignals ($U_{NH}$), um einen vorübergehenden Reaktionsstrom ($Q_R$) zu berechnen, der durch den Meßknoten fließt;
e) Bestimmen der Fehlerrichtung als Vorzeichenfunktion des berechneten vorübergehenden Reaktionsstroms ($Q_R$) derart, daß dann, wenn das Vorzeichen des berechneten vorübergehenden Reaktionsstroms negativ ist, die Fehlerrichtung vorwärts gerichtet ist, während dann, wenn das Vorzeichen des berechneten vorübergehenden Reaktionsstroms positiv ist, die Fehlerrichtung umgekehrt ist.

2. Verfahren zur Bestimmung der Richtung eines Fehlers in einem elektrischen Stromsystem gemäß Anspruch 1, wobei der Schritt e) die folgenden Schritte umfaßt:

e1) Vergleichen des phasenverschobenen, gefilterten Spannungssignals ($U_{NH}$) und des gefilterten Stromsignals ($I_{NH}$) mit den entsprechenden vorbestimmten Grenzwerten ($V_{set}$; $I_{set}$);
e2) Begrenzen des Bereiches des phasenverschobenen, gefilterten Spannungssignals und der gefilterten Stromsignalgröße in ein und demselben Intervall symmetrisch rund um 0, und zwar gemäß den Ergebnissen des Schrittes e1), um dadurch ein begrenztes phasenverschobenes, gefiltertes Spannungssignal ($U_{output}$) und ein begrenztes gefiltertes Stromsignal ($I_{output}$) zu erhalten;

16

e3) Berechnen des vorübergehenden Stroms ($Q_R$), und zwar unter Verwendung des begrenzten, phasenverschobenen, gefilterten Spannungssignals und des begrenzten, gefilterten Stromsignals;

e4) Vergleichen des vorübergehenden Reaktionsstroms mit einem negativen und positiven Wert eines Ermittlungsgrenzwertes (S).

**3.** Verfahren zur Bestimmung der Richtung eines Fehlers in einem elektrischen Stromsystem gemäß Anspruch 1 oder 2, umfassend die folgenden Schritte:

g) Berechnen des Quadratwurzelwertes ($U_{NRMS}$) des abgetasteten Spannungssignals;

h) Vergleichen des berechneten Quadratwurzelwertes mit einem Ausgangsgrenzwert (K);

i) Vergleichen des berechneten Quadratwurzelwertes mit einem Rückzuggrenzwert (K'), wobei dieser Rückzuggrenzwert kleiner ist als der Ausgangsgrenzwert;

j) Abziehen von Schwingungen oder Schwankungen des Vorzeichens des berechneten Quadratwurzelwertes;

k) Vergleichen der Größe der abgezogenen Schwankungen mit einem Impulsfeststellungs-Grenzwert (P);

l) Berechnen, wie viele Male die Größe der abgezogenen Schwingungen größer ist als der Impulsfeststellungs-Grenzwert (P) während eines Grundfrequenzzyklus;

wobei dann, wenn der berechnete Quadratwurzelwert größer ist als der Ausgangsgrenzwert (K) und kleiner ist als der Rückzuggrenzwert (K'), und wenn die berechnete Zahl für Schritt 1) größer ist als eine vorbestimmte Zahl (m) der Fehler als ein intermittierender Fehler bestimmt wird;

wobei dieser Fehler ein permanenter Fehler ist, wenn der berechnete Quadratwurzelwert größer ist als der Ausgangsgrenzwert (K) und kleiner ist als der Rückzuggrenzwert (K'), und zwar während eines vorbestimmten Zeitintervalls ($t_O$).

**4.** Digitales Bandfilter (41) zur Filtrierung und Phasenverschiebung eines abgetasteten Spannungssignals $U_N$ und zum Gewinnen eines phasenverschiebenden, gefilterten Spannungssignals $U_{NH}$ des abgetasteten Spannungssignals nicht ganzzahliger Ordnung einer Grundfrequenz ($f_O$), um das Verfahren gemäß Anspruch 1 umzusetzen, wobei das Filter eine Berechnungseinrichtung zur Berechnung der folgenden Formel aufweist:

$$U_{NH} = \left[ a_0 + \sum_{n=1}^{4} a_n \cdot z^{-n} + b_0 + \sum_{n=1}^{2} b_n \cdot z^{-n} \right] \cdot U_N$$

wobei z eine komplexe Variable ist; mit

$$\begin{cases} a_0 = 1 \\ a_1 = -2 \cdot \cos\left(\dfrac{2 \cdot \pi}{N}\right) \\ a_2 = 0 \\ a_3 = 2 \cdot \cos\left(\dfrac{2 \cdot \pi}{N}\right) \\ a_4 = -1 \end{cases}$$

und

$$\begin{cases} b_0 = 1 \\ b_1 = 2.\exp\left(-\frac{T_0}{N.T_A}\right).\cos\left(k_F \frac{2.\pi}{N}\right) \\ b_2 = \exp\left(-\frac{T_0}{N.T_A}\right) \end{cases}$$

wobei sind: N die Anzahl der Proben pro Grundfrequenzzyklus; $T_O$ eine Zyklusperiode der Grundfrequenz $f_O$, Ta die Signalabtastzeit, $T_A$ = 0,2 s; und $k_F$ = 4,4 für $f_O$ = 220 Hz, 6,6 für $f_O$ = 330 Hz.

**5.** Digitales Bandfilter (41) zum Filtern eines abgetasteten Stromsignals $I_N$, um ein gefiltertes Stromsignal $I_{NH}$ des abgetasteten Stromsignals nicht ganzzahliger Ordnung einer Grundfrequenz $f_O$ zu gewinnen, um das Verfahren gemäß Anspruch 1 durchzuführen, wobei das Filter eine Berechnungseinrichtung zur Berechnung der folgenden Formeln aufweist:

$$I_{NH} = \left[a'_0 + \sum_{n=1}^{4} a'_n.z^{-n} + b'_0 + \sum_{n=1}^{2} b'_n.z^{-n}\right].I_N$$

mit

$$\begin{cases} a'_0 = 1 \\ a'_1 = -2.\cos\left(\frac{2.\pi}{N}\right) \\ a'_2 = 2 \\ a'_3 = -2.\cos\left(\frac{2.\pi}{N}\right) \\ a'_4 = 1 \end{cases}$$

und

$$\begin{cases} b'_0 = 1 \\ b'_1 = 2.\exp\left(-\frac{T_0}{N.T_A}\right).\cos\left(k_F \frac{2.\pi}{N}\right) \\ b'_2 = \exp\left(-\frac{T_0}{N.T_A}\right) \end{cases}$$

wobei sind: N die Anzahl der Proben pro Grundfrequenzzyklus; $T_O$ eine Zyklusperiode der Grundfrequenz $f_O$; Ta die Signalabtastzeit, $T_A$ = 0,2 s; und $k_F$ = 4,4 für $f_O$ = 220 Hz, 6,6 für $f_O$ = 330 Hz.

**Revendications**

1. Procédé de détermination de la direction d'un défaut de mise à la masse par rapport à un noeud de mesure dans un système d'alimentation électrique triphasé, comprenant l'étape suivante :

   a) échantillonnage d'une tension résiduelle ($V_r$) dudit système d'alimentation électrique triphasé (30) et d'un courant résiduel ($I_r$) au niveau dudit noeud de mesure pendant un cycle de fréquence fondamentale afin d'obtenir respectivement un signal de tension résiduelle échantillonnée ($U_N$) et un signal de courant résiduel échantillonné ($I_N$) ;

   **caractérisé en ce qu'**il comprend en outre les étapes suivantes :

   b) filtrage, dans un premier filtre numérique (41), du signal de tension résiduelle échantillonnée ($U_N$) et application d'un déphasage de 90 degrés au signal de tension résiduelle échantillonnée afin d'extraire une composante de signal de tension filtré déphasé du signal de tension résiduelle échantillonnée à un ordre fractionnel de la fréquence fondamentale pour obtenir un signal de tension filtré déphasé ($U_{NH}$) ;

   c) filtrage, dans un second filtre numérique, du signal de courant résiduel échantillonné ($I_N$) pour extraire une composante de signal de courant filtré du signal de courant résiduel échantillonné à un ordre non-entier de la fréquence fondamentale pour obtenir un signal de courant filtré ($I_{NH}$) ;

   d) utilisation du signal de courant filtré ($I_{NH}$) et du signal de tension filtré déphasé ($U_{NH}$) pour calculer une puissance réactive transitoire ($Q_R$) circulant à travers ledit noeud de mesure ;

   e) détermination de la direction de défaut en fonction du signe de la puissance réactive transitoire calculée ($Q_R$) de sorte que si le signe de la puissance réactive transitoire calculée est négatif, alors la direction de défaut est vers l'avant, alors que si le signe de la puissance réactive transitoire calculée est positif, alors la direction de défaut est inversée.

2. Procédé de détermination de la direction d'un défaut dans un système d'alimentation électrique selon la revendication 1, dans lequel l'étape e) comprend les étapes :

   - e1) de comparaison du signal de tension filtré déphasé ($U_{NH}$) et du signal de courant filtré ($I_{NH}$) à des seuils prédéterminés respectifs ($V_{set}$ ; $I_{set}$) ;

   - e2) de limitation de la portée des grandeurs de signal de tension filtré déphasé et de signal de courant filtré dans un même intervalle symétrique autour de 0 selon les résultats de l'étape e1) afin d'obtenir un signal de tension filtré déphasé limité ($U_{output}$) et un signal de courant filtré limité ($I_{output}$) ;

   - e3) de calcul de la puissance réactive transitoire ($Q_R$) en utilisant le signal de tension filtré déphasé limité et le signal de courant filtré limité ;

   - e4) de comparaison de la puissance réactive transitoire calculée à une valeur négative et positive d'un seuil de détection (S).

3. Procédé de détermination de la direction d'un défaut dans un système d'alimentation électrique selon la revendication 1 ou 2, comprenant en outre :

   g) le calcul de la valeur quadratique moyenne ($U_{NRMS}$) du signal de tension échantillonné ;

   h) la comparaison de la valeur quadratique moyenne calculée à un seuil de départ (K) ;

   i) la comparaison de la valeur quadratique moyenne calculée à un seuil d'inconvénient (K'), ledit seuil d'inconvénient étant plus petit que le seuil de départ ;

   j) l'extraction d'oscillations d'une signature de la valeur quadratique moyenne calculée ;

   k) la comparaison de la grandeur des oscillations extraites à un seuil de détection d'impulsion (P) ;

   l) le calcul du nombre de fois où la grandeur des oscillations extraites est plus grande que le seuil de détection d'impulsion (P) pendant un cycle de fréquence fondamentale ;

   dans lequel si la valeur quadratique moyenne calculée est supérieure au seuil de départ (K) et inférieure audit seuil d'inconvénient (K') et si le nombre calculé à l'étape 1) est supérieur à un nombre prédéterminé (m), alors ledit défaut est déterminé comme un défaut intermittent ;

   alors que ledit défaut est un défaut permanent si la valeur quadratique moyenne calculée est supérieure au seuil de départ (K) et inférieure audit seuil d'inconvénient (K') pendant un intervalle temporel prédéterminé ($t_o$).

4. Filtre passe-bande numérique (41) destiné à filtrer et à déphaser un signal de tension échantillonné $U_N$ et à extraire un signal de tension filtré déphasé $U_{NH}$ du signal de tension échantillonné à un ordre non-entier d'une fréquence fondamentale $f_0$ pour mettre en oeuvre le procédé selon la revendication 1, dans lequel ledit filtre comprend des moyens de calcul destinés à calculer la formule suivante :

$$U_{NH} = \left[a_0 + \sum_{n=1}^{4} a_n . z^{-n} + b_0 + \sum_{n=1}^{2} b_n . z^{-n}\right] . U_N$$

où z est une variable complexe
avec

$$\begin{cases} a_0 = 1 \\ a_1 = -2.\cos\left(\dfrac{2.\pi}{N}\right) \\ a_2 = 0 \\ a_3 = 2.\cos\left(\dfrac{2.\pi}{N}\right) \\ a_4 = -1 \end{cases}$$

et

$$\begin{cases} b_0 = 1 \\ b_1 = 2.\exp\left(-\dfrac{T_0}{N.T_A}\right).\cos\left(k_F \dfrac{2.\pi}{N}\right) \\ b_2 = \exp\left(-\dfrac{T_0}{N.T_A}\right) \end{cases}$$

où : $N$ est le nombre d'échantillons par cycle de fréquence fondamentale ; $T_0$ est une période de cycle de la fréquence fondamentale $f_0$ ; Ta est le temps d'échantillonnage de signal, $T_A$ = 0,2 s ; et $k_F$ = 4,4 pour $f_0$ = 220 Hz, 6,6 pour $f_0$ = 330 Hz.

5. Filtre passe-bande numérique (41) destiné à filtrer un signal de courant échantillonné $I_N$ et à extraire un signal de courant filtré $I_{NH}$ du signal de courant échantillonné à un ordre non-entier d'une fréquence fondamentale $f_0$ pour mettre en oeuvre le procédé selon la revendication 1, dans lequel ledit filtre comprend des moyens de calcul destinés à calculer la formule suivante :

$$I_{NH} = \left[a'_0 + \sum_{n=1}^{4} a'_n . z^{-n} + b'_0 + \sum_{n=1}^{2} b'_n . z^{-n}\right] . I_N$$

avec

$$\begin{cases} a'_0 = 1 \\ a'_1 = -2.\cos\left(\dfrac{2.\pi}{N}\right) \\ a'_2 = 2 \\ a'_3 = -2.\cos\left(\dfrac{2.\pi}{N}\right) \\ a'_4 = 1 \end{cases}$$

et

$$\begin{cases} b'_0 = 1 \\ b'_1 = 2.\exp\left(-\frac{T_0}{N.T_A}\right).\cos\left(k_F\frac{2.\pi}{N}\right) \\ b'_2 = \exp\left(-\frac{T_0}{N.T_A}\right) \end{cases}$$

où : $N$ est le nombre d'échantillons par cycle de fréquence fondamentale ; $T_0$ est une période de cycle de la fréquence fondamentale $f_0$ ; Ta est le temps d'échantillonnage de signal, $T_A = 0{,}2$ s et $k_F = 4{,}4$ pour fo = 220 Hz, 6,6 pour $f_0$ = 330 Hz.

FIG.1

FIG.2

FIG.3

FIG.4

FIG.5

FIG.6A

FIG.6B

FIG.6C

FIG.6D

FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012123708 A

**Non-patent literature cited in the description**

- **J. HORAK.** Directional Overcurrent Relaying (67) Concepts. *Basler Electr., IEEE, Conference Publications, 2006. 59th Annual Conference for Protective Relay Engineers,* 04 April 2006

- **JOHNSON,G. ; SCHROEDER, M. ; DALKE, G.** A Review of System Grounding Methods and Zero Sequence Current Sources. *IEEE, , 2008 61st Annual Conference for Protective Relay Engineers,* 01 April 2008